# EUROPÄISCHE PATENTSCHRIFT

(11) **EP 2 510 763 B1**
(45) Veröffentlichungstag und Bekanntmachung des Hinweises auf die Patenterteilung: **08.06.2016**
(21) Anmeldenummer: 10781446.9
(22) Anmeldetag: 24.11.2010
(51) Int. Cl.: H05K 7/14

(54) **ELEKTRONISCHE BAUGRUPPE**
ELECTRONIC ASSEMBLY
MODULE ÉLECTRONIQUE

(30) Priorität: 08.12.2009 DE 102009057272
(43) Veröffentlichungstag der Anmeldung: 17.10.2012
(73) Patentinhaber: Diehl BGT Defence GmbH & Co. KG, 88662 Überlingen (DE)
(72) Erfinder: KISAKÜREK, Hakan, 81476 München (DE)
(74) Vertreter: Diehl Patentabteilung
(86) Internationale Anmeldenummer: PCT/EP2010/007118
(87) Internationale Veröffentlichungsnummer: WO 2011/069603

(56) Entgegenhaltungen:
- EP-A2- 1 120 695
- GB-A- 2 181 900
- US-A1- 2009 043 937
- US-B1- 6 778 389

## Beschreibung

Die Erfindung betrifft eine elektronische Baugruppe mit mehreren Funktionseinheiten, die jeweils ein mit elektronischen Bausteinen bestücktes Plattenelement umfassen, das jeweils eine Anzahl von in zumindest einer Reihe angeordnete Kontaktstellen aufweist, und mit einer Kontaktplatte, die für jedes Plattenelement zumindest eine Reihe Kontaktaufnahmen aufweist, die mit den Kontaktstellen ihres Plattenelements unmittelbar elektrisch verbunden sind, und diese Reihen in ihrer Längsrichtung auf eine Seite der Kontaktplatte weisen.

Elektronische Baugruppen zur Steuerung komplexer Vorgänge umfassen üblicherweise mehrere Funktionseinheiten auf jeweils einer Platine, denen unterschiedliche Aufgaben zugewiesen sind. Diese komplexe Steuerungsaufgabe wird hierbei durch ein Zusammenwirken der die verschiedenen Teilaufgaben bearbeitenden Funktionseinheiten gelöst.

Die mechanische und signaltechnische Verbindung der einzelnen Funktionseinheiten wird üblicherweise über eine sogenannte Backplane realisiert, die auch Busplatine oder Rückplatte genannt wird. Eine solche Backplane umfasst einen Steckplatz für jede Funktionseinheit, durch die die Baugruppe mechanisch und signaltechnisch fest mit der Backplane verbunden ist. Die einzelnen Steckplätze sind je entsprechend der Aufgabe der elektronischen Baugruppe und der einzelnen Teilaufgaben der Funktionseinheiten miteinander verdrahtet, sodass die Funktionseinheiten miteinander kommunizieren und ihre Teilaufgaben durch Datenaustausch untereinander lösen können. Diese elektrischen Verbintiungen, die die Backplane zwischen den Steckplätzen herstellt, können sehr unterschiedlich sein und bestimmen die Architektur der Backplane und der elektronischen Baugruppe.

Durch die aufgabenspezifische Verdrahtung sind Backplanes ein zentraler Bestandteil von integrierten, rechnergesteuerten Systemen, vor allem der Telekommunikation, der Mess- und Automatisierungstechnik, der Medizintechnik oder Luftfahrt und Bahntechnik. Als zentrales Element bildet die Backplane eine Bus-Architektur zur Verbindung der einzelnen Pins der Steckplätze und damit der einzelnen Kontaktstellen aller Funktionseinheiten.

Es ist eine Aufgabe der vorliegenden Erfindung, eine elektronische Baugruppe anzugeben, die kompakt und kostengünstig hergestellt werden kann.

Diese Aufgabe wird durch eine elektronische Baugruppe der eingangs genannten Art gelöst, die erfindungsgemäß eine von der Kontaktplatte separate Kommunikationseinheit zur Kommunikation mit Bausteinen der Plattenelemente aufweist, die über mehrere Datenleitungen mit der Kontaktplatte verbunden ist, wobei die Datenleitungen auf der Seite mit der Kontaktplatte kontaktiert sind, auf die die Reihen weisen. Durch eine solche Geometrie kann eine Entflechtung von Datenleitungen, insbesondere zwischen den Funktionseinheiten, erreicht werden, sodass ein kompaktes Design der elektronischen Baugruppe ermöglicht wird.

Die Erfindung geht hierbei von der Überlegung aus, dass zumindest einzelne der Funktionseinheiten mit Systemen außerhalb der elektronischen Baugruppe kommunizieren, um eine Steuerung zu bewirken oder Sensor- oder Steuersignale empfangen zu können. Hierzu sind die einzelnen Funktionseinheiten entsprechend ihrer Aufgaben zur Kommunikation nach außen vorbereitet, sodass sie in Bezug zu einer benötigten Datenübertragungsrate, Datenform und/oder einem Übertragungsprotokoll mit entsprechenden Einstellungen versehen sind. Werden mehrere ähnliche Baugruppen zur Bewältigung ähnlicher Aufgaben bei ähnlichen Steuerprozessen hergestellt, so ist es vorteilhaft, wenn die unterschiedlichen Baugruppen zumindest hinsichtlich ihrer Funktionseinheiten identisch ausgeführt sein können, um eine Fertigung zu vereinfachen. Dieser Vereinfachung steht die notwendige Kommunikationsanpassung der einzelnen Funktionseinheiten an externe Steuereinheiten, Aktuatoren oder Sensoren im Wege. Da eine solche Kommunikationsanpassung in der Regel für mehrere Funktionseinheiten einer elektronischen Baugruppe notwendig ist, ist es besonders sinnvoll, sie zu zentralisieren. Als zentrale Funktionseinheit bietet sich hierbei eine Backplane an, die eine zentrale Funktionseinheit der Baugruppe darstellt.

Die Erfindung geht von der weiteren Überlegung aus, dass die einzelnen Funktionseinheiten üblicherweise nebeneinander an der Kontaktplatte angeordnet sind, sodass beispielsweise eine Kommunikation zwischen den beiden außen angeordneten Funktionseinheiten Datenleitungen notwendig macht, die an den innen liegenden Funktionseinheiten vorbeiführen. Je mehr Funktionseinheiten beteiligt sind, desto komplexer und großvolumiger wird die Kontaktplatte, bedingt durch mehr und längere Datenleitungen. Bei einer Trennung der Backplane in einen Kontaktteil - die Kontaktplatte - und in einen Kommunikationsteil - die Kommunikationseinheit - kann der Vorteil erreicht werden, dass komplexe Datenleitungswege, aus der Kontaktplatte herausgenommen werden können. Hierdurch kann die Backplane insgesamt kompakt und einfach gehalten werden.

Die Kontaktplatte kann eine Backplane sein, die die einzelnen Funktionseinheiten sowohl signaltechnisch als auch mechanisch miteinander verbindet. Die Längsrichtung ist zweckmäßigerweise parallel zum betreffenden Plattenelement, wobei insbesondere die Längsrichtungen aller Reihen parallel sind. Zweckmäßigerweise sind die Datenleitungen auf der Seite, auf die die Reihen weisen, mit der Kontaktplatte mechanisch verbunden. Insbesondere ist die Seite gerade, zumindest im Bereich in dem die Datenleitungen mit ihr kontaktiert sind. Die Verbindung der Kontaktstellen mit den Kontaktaufnahmen kann eine Steckverbindung sein. Besonders vorteilhaft ist die Verbindung durch Durchstecktechnik und Verlötung der Kontaktstellen in den Kontaktaufnahmen realisiert.

Die elektronische Baugruppe kann eine Steuereinheit zur eigenständigen Steuerung eines Systems sein, beispielsweise zur Steuerung eines Flugkörpers. Die Plattenelemente können Platinen sein, die über die Kontaktplatte auch mechanisch miteinander verbunden sind. Ein Baustein kann ein Prozessor sein oder einen oder mehrere elektronische Bauelemente umfassen. Zweckmäßigerweise bildet die Kommunikationseinheit ein eigenes Plattenelement, das von der Kontaktplatte separat in der elektronischen Baugruppe gehaltert ist. Hierbei ist es vorteilhaft, wenn die Kommunikationseinheit mechanisch separat von der Kontaktplatte in beispielsweise einem Gehäuse gehaltert ist.

Die Kommunikationseinheit ist vorteilhafterweise so ausgeführt, dass sie eine informationsverbindende Kommunikationsschnittstelle zwischen zumindest einem internen Kommunikationsmodus einer Funktionseinheit mit einem davon unterschiedlichen externen Kommunikationsmodus einer Einheit außerhalb der elektronischen Baugruppe bildet. Als Kommunikationsschnittstelle wird eine Einheit angesehen, die zum Anpassen zweier unterschiedlicher Kommunikationsmodi aneinander vorgesehen ist. Die Unterschiedlichkeit kann in unterschiedlichen Kommunikationsprotokollen, Datenübergabeprotokollen, Kommunikationsdatenraten, Signalamplituden und dergleichen liegen. Die externe Einheit kann eine externe Steuereinheit, Sensoren, Aktuatoren oder dergleichen sein. Zusätzlich kann die Kommunikationseinheit eine Kommunikationsschnittstelle zwischen einem internen Kommunikationsmodus einer Funktionseinheit und einem unterschiedlichen Kommunikationsmodus einer weiteren Funktionseinheit der elektronischen Baugruppe sein.

Es ist außerdem vorteilhaft, wenn eine durch die Datenleitungen hergestellte Datenverbindung zwischen den Funktionseinheiten und der Kommunikationseinheit zumindest einen Highspeedbus bilden. Gegebenenfalls kann es ausreichend sein, wenn nur die interne Verbindung zwischen den Funktionseinheiten, und damit Datenleitungen in der Kontaktplatte, als Highspeedbus ausgeführt sind. Als ein Highspeedbus kann im Folgenden eine Busverbindung mit einer Datenrate von zumindest 1 Mbit/s verstanden werden.

In einer vorteilhaften Ausführungsform der Erfindung sind die Datenleitungen signaltechnisch unmittelbar mit den Plattenelementen verbunden. Ein Signal von einer Funktionseinheit zur Kommunikationseinheit passiert somit insbesondere keine aktiven Bauelemente, wie ICs oder passive Bauelemente, wie Widerstände oder Kondensatoren. Eine unmittelbare mechanische Verbindung ist hierdurch nicht vorgegeben, da die Datenleitungen zweckmäßigerweise mechanisch über die Kontaktplatte mit den Plattenelementen verbunden sind.

Eine mechanisch beständige und doch konstruktiv sehr flexible Ausführung der Datenleitung kann erreicht werden, wenn diese zur Kommunikationseinheit in einem flexiblen Band verlaufen. Sie könnten alle parallel als Flachbandkabel verlaufen, wobei sie zweckmäßigerweise in eine Folie eingebunden sind. Durch eine Starr-Flex-Starr-Verbindung der Kontaktplatte mit der Kommunikationseinheit wird auch eine hohe Stabilität gegen Schäden durch beispielsweise Rütteln und Vibration erreicht. Die Belastbarkeit und Flexibilität der Konstruktion kann weiter gesteigert werden, wenn weitere Datenleitungen von der Kommunikationseinheit in Richtung einer Schnittstelle nach außen in einem flexiblen Band verlaufen. Dieses flexible Band kann gleich wie das flexible Band zur Kontaktplatte sein, wobei die Schnittstelle eine Schnittstelle zu beispielsweise einer externen Steuereinheit, Funktionseinheit, Aktuatoren, Sensoren oder dergleichen ist.

Vorteilhafterweise ist die Kommunikationseinheit als Platte ausgeführt, die zweckmäßigerweise angewinkelt zur Kontaktplatte angeordnet ist. Der Winkel zwischen der Kontaktplatte und der Kommunikationseinheit ist zweckmäßigerweise zumindest im Wesentlichen rechtwinklig.

Eine Gehäusefunktion kann erreicht und somit können zusätzliche Bauteile eingespart werden, wenn die Kommunikationseinhit und die Kontaktplatte die Plattenelemente von zumindest zwei Seiten umgreifen. Hierbei ist eine rechtwinklige Anordnung der Kommunikationseinheit und der Kontaktplatte besonders vorteilhaft.

Das Modularitätsprinzip kann weiter gefördert werden, wenn die Kontaktplatte passiv ist und die Kommunikationseinheit aktiv. Unter Aktivität wird in diesem Zusammenhang die Bestückung mit aktiven Bauelementen, wie ICs oder passiven Bauelementen, wie Widerständen oder Kondensatoren verstanden. Dementsprechend ist die Kontaktplatte passiv, wenn sie keine aktiven oder passiven Bauelemente trägt, sondern lediglich mit z.B. Datenleitungen versehen ist, in denen die Daten bzw. Signale insbesondere ohne jede Datenverarbeitung von einem Eingangskontakt zu einem Ausgangskontakt geführt werden.

Außerdem wird vorgeschlagen, dass als zusätzliches Merkmal oder insbesondere anstelle der erfindungsgemäßen Merkmale im kennzeichnenden Teil des Anspruchs 1 zumindest eines der Plattenelemente mittels eines Gehäuses von den anderen Plattenelementen abgeschirmt ist. Zweckmäßigerweise umgibt das Gehäuse das Plattenelement. Dieses kann somit besonders fest, sicher und störungsunauffällig gelagert werden. Sind zumindest zwei der Plattenelemente von jeweils einem Gehäuse umgeben, die starr miteinander verbunden sind, kann eine besonders stabile Lagerung der Funktionseinheiten gewährleistet werden. Insbesondere sind alle Plattenelemente bzw. Funktionseinheiten in dieser Form gelagert.

Außerdem wird vorgeschlagen, dass das Gehäuse oder die Gehäuse jeweils eine Ausformung aufweisen, die einen inneren Bereich des Plattenelements bzw. betreffenden Plattenelements mechanisch kontaktiert. Auf diese Weise kann eine Abstützung des Plattenelements im inneren Bereich erreicht werden, wobei als innerer Bereich ein solcher Bereich verstanden wird, der zumindest 2 cm vom Plattenrand entfernt ist. Zweckmäßigerweise ist die Kontaktierung ein inselförmiger Kontakt, der vom Rand des entsprechenden Plattenelements entfernt ist.

In einer weiteren Ausführungsform der Erfindung ist das Gehäuse metallisch und eine Ausformung des Gehäuses kontaktiert das Plattenelement thermisch. Die thermische Verbindung liegt zweckmäßigerweise im Bereich der mechanischen Kontaktierung, sodass im inneren Bereich des Plattenelements eine Wärmesenke ausführbar ist. Hierdurch kann ein Prozessor im inneren Bereich des Plattenelements besonders effektiv gekühlt werden. Eine alternative oder zusätzliche Kühlung wird erreicht, wenn das Plattenelement insbesondere rund um das Gehäuse über eine thermische Kontaktschicht, insbesondere eine Goldschicht, kontaktiert. Insbesondere im inneren Bereich ist eine thermische Kontaktierung über ein Gelpad vorteilhaft.

Weitere Vorteile ergeben sich aus der folgenden Zeichnungsbeschreibung. In der Zeichnung sind Ausführungsbeispiele der Erfindung dargestellt. Die Zeichnung und die Beschreibung enthalten zahlreiche Merkmale in Kombination, die der Fachmann zweckmäßigerweise auch einzeln betrachten und zu sinnvollen weiteren Kombinationen zusammenfassen wird.

Es zeigen:
- Fig. 1: Ein Schaltbild einer elektronischen Baugruppe mit mehreren Funktionseinheiten, einer Kontaktplatte und einer Kommunikationseinheit,
- Fig. 2: eine alternative elektronische Baugruppe mit einem Router auf der Kommunikationseinheit,
- Fig. 3: eine schematische perspektivische Außenansicht auf die elektronische Baugruppe,
- Fig. 4: eine Ansicht auf eine der Funktionseinheiten der elektronischen Baugruppe in einem Gehäuse und
- Fig. 5: eine Ansicht in das Gehäuse ohne die Funktionseinheit.

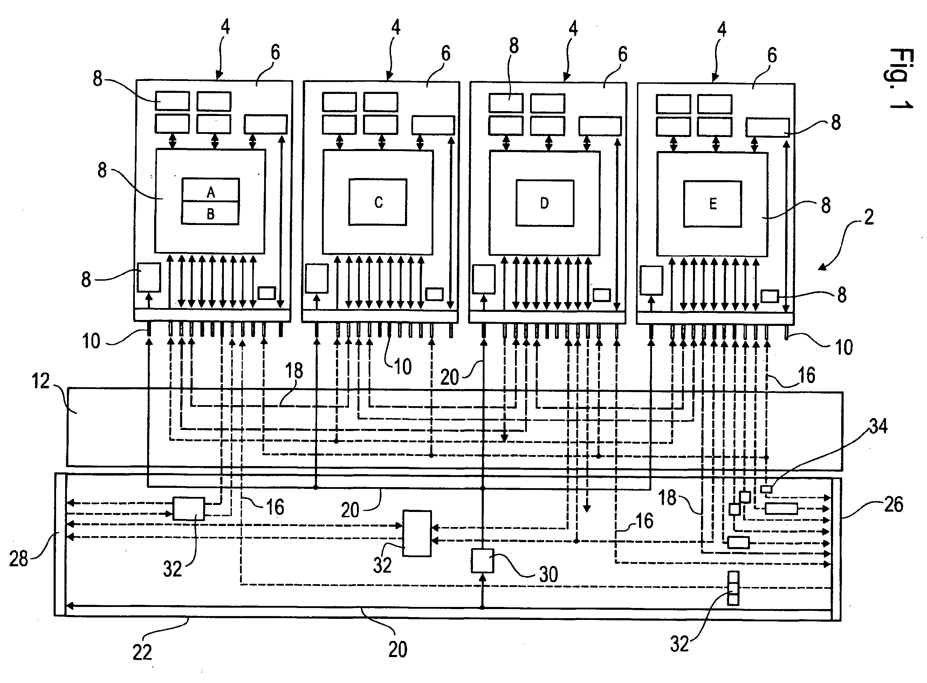

Fig. 1 zeigt einen schematischen Schaltplan einer elektronischen Baugruppe 2 mit vier Funktionsgruppen 4, die jeweils ein Plattenelement 6 in Form einer Platine und darauf angeordnete elektronische Bausteine 8 umfasst. Die elektronische Baugruppe 2 dient zur Steuerung eines Lenkflugkörpers und zur Auswertung von Signalen eines Suchkopfs. Als Baustein 8 können ein oder mehrere elektronische Bauelemente verstanden werden, die einzeln oder gemeinsam eine Funktion erfüllen. Bei einer jeden dieser Funktionsgruppen 4 ist einer der Bausteine 8 ein zentraler Prozessor, der mit Software, also einem oder mehreren elektronischen Datenverarbeitungsprogrammen, beispielsweise in Form von Firmware und zusätzlicher frei programmierbarer Software, ausgerüstet ist. Hierdurch ist jeder Prozessor in der Lage, einen Aufgabenbereich oder eine Funktion zu bearbeiten, wobei die Funktionen der Prozessoren verschieden sind und in Fig. 1 symbolisch mit den Buchstaben A bis E angedeutet sind. Abgesehen von der unterschiedlichen Programmierung sind die Funktionsgruppen 4 in Bezug auf ihre Hardware, also ihre elektronischen Bausteine 8 und deren Verdrahtung, also die Leitungsführung untereinander und nach außen, vollkommen identisch ausgeführt und sind auch sonst identisch.

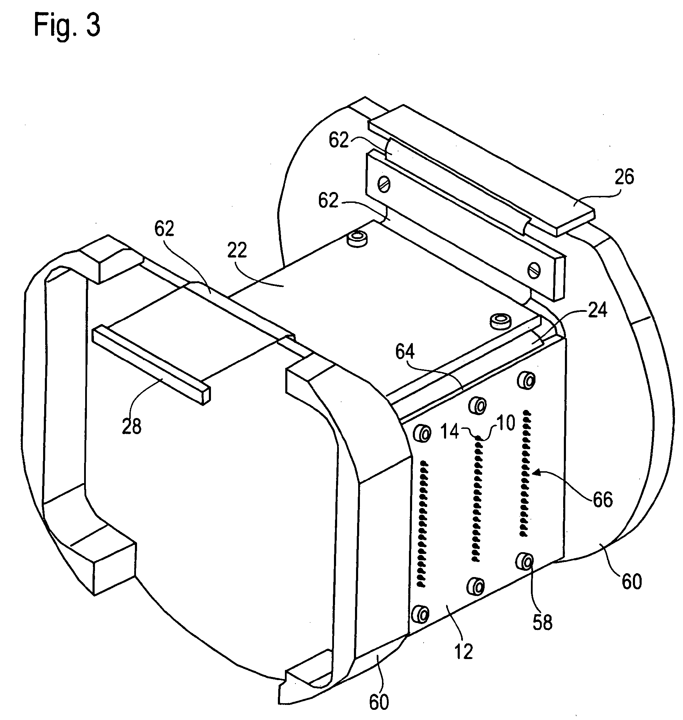

Jedes der Plattenelemente 6 trägt eine Anzahl von Kontaktstellen 10 in Form von Pins, durch die die Funktionsgruppen 4 signaltechnisch und zur Stromversorgung sowie auch mechanisch mit einer Kontaktplatte 12 verbunden sind. Hierzu sind die Kontaktstellen 10 in entsprechende Kontaktaufnahmen 14 (siehe Fig. 3) der Kontaktplatte 12 in Form von metallisierten Löchern eingesteckt und verlötet, sodass eine feste mechanische und elektrische Verbindung zwischen dem Plattenelement 6 und der Kontaktplatte 12 zustande kommt. Die Kontaktplatte 12 wiederum ist über mehrere Datenleitungen 16, 18 sowie Stromversorgungsleitungen 20 mit einer Kommunikationseinheit 22 verbunden, wobei die Datenleitungen 16, 18 und Stromversorgungsleitungen 20 in eine Folie 24 (siehe Fig. 3) in Form eines Flachbandkabels eingebunden sind.

In der Kontaktplatte 12 sind die Datenleitungen 16, 18 und weitere Datenleitungen 16, 18 so verlegt, dass eine funktionsbezogene Kommunikation der Funktionsgruppen 4 untereinander ermöglicht wird. So sind als Highspeedbusse ausgeführte Datenleitungen 18, die Fig. 1 lang gestrichelt angedeutet sind, zwischen den Funktionsgruppen 4 in der Art angeordnet, dass jede der Funktionsgruppen 4 direkt oder über eine weitere Funktionsgruppe 4 mit allen Funktionsgruppen 4 über eine solche Datenleitung verbunden ist. Eine weitere solche Datenleitung 18 ist über die Kommunikationseinheit 22 nach außen, also nach außerhalb der elektronischen Baugruppe 2, geführt und mündet hierzu in eine Schnittstelle 26, beispielsweise in Form eines Steckers, zur Verbindung mit einem externen Gerät, z. B. einer Steuereinheit oder einer Einheit mit Aktuatoren zur Betätigung mechanischer Gegenstände. Über weitere Datenleitungen 16, die in Fig. 1 kürzer gestrichelt angedeutet sind, kommunizieren die Funktionsgruppen 4 über die Schnittstelle 26 und eine weitere Schnittstelle 28 mit der Außenwelt, z. B. weiteren Fünktionsgruppen, Sensoren oder dergleichen, die hierfür an die Schnittstellen 26, 28 signaltechnisch angeschlossen werden.

Über eine Stromversorgungsleitung 20 kann die Kommunikationseinheit 22 von Extern über eine Spannung zur Stromversorgung, insbesondere 5 V, 12 V oder 28 V versorgt werden, die einer Stromversorgungseinheit 30 zugeführt werden. In dieser wird die Spannung auf eine niedrigere Spannung herunter transformiert, beispielsweise 3,3 V und über die weiteren Stromversorgungsleitungen 20 an die Funktionsgruppen 4 weitergegeben. Diese verfügen jeweils ebenfalls über eine Stromversorgungseinheit, in Fig. 1 als Baustein 8 angegeben, zur weiteren Transformierung in eine oder mehrere Arbeitsspannungen der Bausteine 8 der Funktionsgruppen 4, beispielsweise 1,0 V, 1,8 V und 2,5 V.

Die Kontaktplatte 12 und die Kommunikationseinheit 22 übernehmen in ihren Funktionen die Aufgaben einer sogenannten Backplane, die mehrere Funktionseinheiten miteinander verbindet. Bei dem in Fig. 1 dargestellten Ausführungsbeispiel ist diese an sich üblicherweise einheitliche Backplane in zwei Einheiten unterteilt, nämlich die passive Kontaktplatte 12, die also keinerlei elektronische Bausteine trägt, und die aktive Kommunikationseinheit 22, die als Kommunikationsschnittstelle für die Funktionsgruppen 4 bzw. deren Bausteine 8 nach extern dient. Hierzu trägt die Kommunikationseinheit 22 Bauelemente 32, die zur Anpassung der Kommunikation der Bausteine 8 der Funktionsgruppen 4 an eine nach extern durchzuführende Kommunikation vorbereitet sind. So wird durch die Bauelemente 32 beispielsweise ein Kommunikationsprotokoll und/oder eine Amplitude von Kommunikationssignalen von einer internen Kommunikation an eine externe Kommunikation und andersherum angepasst, sodass eine Kommunikationsanpassung der einzelnen Funktionsgruppen 4 entfallen kann. Unabhängig von deren durch die Buchstaben A bis E angedeuteten Aufgaben können diese also gleich ausgeführt sein, da die mit den Aufgaben verbundenen Kommunikationseigenschaften nach außen durch entsprechende Bauelemente 32 der Kommunikationseinheit 22 ausgeführt werden.

Anhand des in Fig. 1 darstellten Ausführungsbeispiels kann dargestellt werden, wie mehrere elektronische Baugruppen, die analog zur Baugruppe 2 ausgeführt sind, für verschiedene Aufgaben effizient hergestellt werden können. So kann neben der in Fig. 1 dargestellten elektronischen Baugruppe 2 eine weitere Baugruppe 2 gedacht werden, die für eine andere Steuerungsaufgabe, beispielsweise eines anderen Flugkörpers oder eines anderen Automatisierungsgeräts, vorbereitet ist. Beide elektronischen Baugruppen 2 umfassen jeweils eine Anzahl von Funktionsgruppen 4, wobei die Anzahlen nicht gleich sein müssen. Die Funktionsgruppen 4 sind jeweils in eine Kontaktplatte 12 eingesteckt oder darin eingelötet und entsprechend der Darstellung in Fig. 1 mit der Kommunikationseinheit 22 verbunden.

Entsprechend der Aufgaben sind die zentralen Prozessoren der Funktionsgruppen 4 programmiert. Ansonsten können sämtliche Funktionsgruppen 4 beider Baugruppen 2 identisch ausgeführt sein. Bei ähnlichen Aufgaben können auch die beiden Kontaktplatten 12 der beiden Baugruppen 2 gleich ausgeführt sein, wobei nur die Kommunikationseinheit 22 an die entsprechenden Steuergeräte, Sensoren oder dergleichen angepasst ist. Hierzu können die beiden Kommunikationseinheiten 22 unterschiedliche Bauelemente 32 tragen und unterschiedlich verdrahtet sein, also z.B. unterschiedliche Leitungsausgänge an den Schnittstellen 26, 28 aufweisen. Bei sehr unterschiedlichen Aufgaben der beiden Baugruppen 2 können auch die Kontaktplatten 12 entsprechend an die Aufgaben angepasst sein, sodass die Verdrahtung, also die Leitungsführungen der Leitungen 16, 18 und gegebenenfalls auch der Stromversorgungsleitungen 20, anders und auf die Aufgaben optimiert ist. Durch diesen modularen Aufbau können für beide Baugruppen 2 stets die gleichen Funktionsgruppen 4 und gegebenenfalls sogar die gleichen Kontaktplatten 12 verwendet werden. Anpassungen der elektronischen Baugruppen 2 an verschiedene Aufgaben kann daher durch einfache Fertigungsänderungen der Kommunikationseinheit 22 und gegebenenfalls der Kontaktplatte 12 erreicht werden. Eine Konfiguration der Funktionsgruppen 4 und eine Anpassung der Backplane an diese Konfigurationen ist nicht mehr notwendig.

Eine weitere Aufgabe, die der Kommunikationseinheit 22 zugeordnet werden kann, ist eine Einschaltsequenzierung der einzelnen Funktionsgruppen 4. Um eine Spannungsquelle nicht zu überrasten, ist es vorteilhaft, wenn die einzelnen Funktionsgruppen 4 bei einer Initialisierung der Baugruppe 2 nicht zeitgleich starten, da in einem solchen Fall viele Bausteine 8 einen hohen Stromverbrauch aufweisen, die hohe Anforderungen an die Stromversorgung stellt. War es bisher üblich, dass eine erste Funktionsgruppe 4 als erste einschaltet, dann ein Einschaltsignal an eine nächste Funktionsgruppe 4 gibt, die wiederum das Einschalten einer weiteren Funktionsgruppe 4 triggert, kann eine solche Einschaltsequenzierung nun durch ein Bauelement 32 der Kommunikationseinheit 22 durchgeführt werden. Auch hierdurch entfällt eine spezielle Anpassung der Funktionsgruppen 4 an eine gewünschte Einschaltsequenzierung, da diese von der Aufgabe der Einschaltsequenzierung völlig befreit sind. Entsprechende Signale können von einem Bauelement 32 über eine Datenleitung 16 an die Funktionsgruppen 4 gegeben werden, die auf Kommando der Kommunikationseinheit 22 einschalten. Durch diese an die Modularität der Baugruppe 2 angepasste Aufgabenverteilung kann die Standardisierbarkeit der Funktionsgruppen 4 weiter erhöht werden.

Bei elektronischen Baugruppen 2 kommt einer Fehlererkennung und Fehlerbeseitigung eine hohe Bedeutung zu. Zur einfachen und zentralisierten Bewältigung dieser Aufgabe trägt die Kommunikationseinheit 22 ein Bauelement 34, das als Testschnittstelle konfiguriert ist. Durch diese Testschnittstelle kann auf jede der Funktionsgruppen 4 mit Testsignalen zugegriffen und entsprechende Ausgangssignale zur Überprüfung der Funktion der Funktionsgruppen 4 an der Schnittstelle 26 abgegriffen werden. Eine entsprechende Vorbereitung an den einzelnen Funktionsgruppen 4 kann entfallen, sodass diese - unabhängig von ihrer durch Programmierung aufgeprägten Funktionen - auf die korrekte Bearbeitung ihrer Aufgaben getestet werden können. Besondere Anforderungen an die Hardware oder Verdrahtungen durch solche Tests können in der Kommunikationseinheit 22 implementiert werden. Eine in Bezug auf die unterschiedlichen Aufgaben der Funktionsgruppen 4 notwendige Anpassung betrifft daher wiederum nur die Kommunikationseinheit 22, sodass eine hohe Standardisierung der übrigen Funktionseinheiten der Baugruppe 2 erreichbar ist.

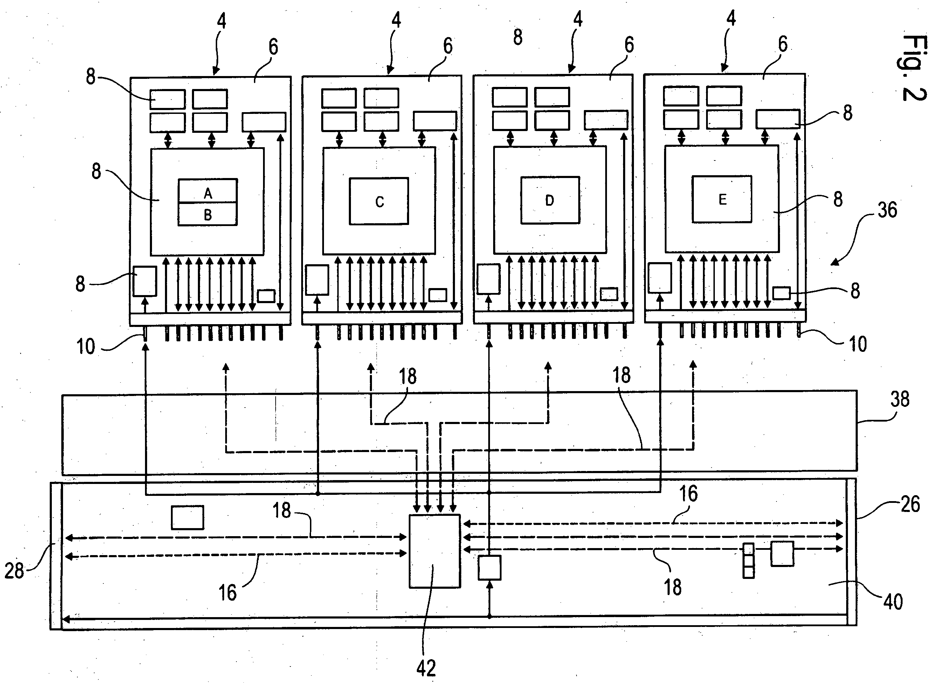

Ein weiteres Ausführungsbeispiel einer elektronischen Baugruppe 36 ist in Fig. 2 dargestellt. Die nachfolgende Beschreibung beschränkt sich im Wesentlichen auf die Unterschiede zum Ausführungsbeispiel aus Fig. 1, auf das bezüglich gleichbleibender Merkmale und Funktionen verwiesen wird. Im Wesentlichen gleichbleibende Bauteile sind grundsätzlich mit den gleichen Bezugszeichen beziffert und nicht erwähnte Merkmale sind in den folgenden Ausführungsbeispielen übernommen, ohne dass sie erneut beschrieben sind.

Wiederum ist die elektronische Baugruppe 36 mit den identischen Funktionsgruppen 4 und einer Kontaktplatte 38 versehen, die mit einer Kommunikationseinheit 40 verbunden ist. Die Kommunikationseinheit 40 trägt eine Router 42, der über Datenleitungen 18, die als Highspeedbus ausgeführt sind, mit einzelnen Funktionsgruppen 4 verbunden ist. Die Busverbindung vom Router 42 zu den Funktionsgruppen 4 ist durch die von den Kontaktstellen 10 entfernter endenden Pfeilen der Datenleitungen 18 nur angedeutet und in Fig. 2 den Kontaktstellen 10 nicht konkret zugewiesen. Über Busverbindungen ist der Router 42 auch mit den beiden Schnittstellen 26, 28 verbunden, ebenfalls nur schematisch dargestellt. Die gesamte Kommunikation zwischen den Funktionsgruppen 4 verläuft über den Router 42, der hierdurch über sämtliche Datenaustauschschritte der Funktionsgruppen 4 untereinander und nach und von außen informiert ist.

Der Router 42 bildet somit eine Kommunikationsdrehscheibe der elektronischen Baugruppe 36, die nicht blockierend ausgeführt ist, also in ihrer Kommunikationsdatenrate zulässt, dass sämtliche mit ihr verbundenen Bausteine 8 zeitgleich mit der ihnen zugewiesenen Datenrate kommunizieren. Der Router 42 ist dazu vorbereitet, die gesamten oder auch nur festgelegte einzelne Bereiche der Kommunikation der Funktionsgruppen 4 untereinander und insbesondere auch der Funktionsgruppen 4 nach außen zu protokollieren. Um eine Abfrage von Kommunikationsdaten von außen zu ermöglichen, ist der Router 42 mit einer Datenschnittstelle nach außen ausgeführt.

Auf diese Weise können von außen Daten zu Kommunikationsvorgängen der Funktionsgruppen 4 abgerufen werden und beispielsweise für einen Funktionstest der Funktionsgruppen 4 oder eine Fehlerbehebung (Debugging) verwendet werden. Zweckmäßig ist es, diese Kommunikationsdaten oder Teile davon zu visualisieren, also auf einen Bildschirm z. B. grafisch darzustellen, sodass Kommunikationsfehler schnell gefunden und hieraus auf Funktionsfehler der Funktionsgruppen 4 geschlossen werden können. Es ist auch möglich, dass bereits der Router 42 dazu vorbereitet ist, beispielsweise durch eine entsprechende Programmierung, Kommunikationsdaten mit Solldaten zur Kommunikation zu vergleichen und aus diesem Vergleich resultierende Daten nach außen zu geben, sodass eine Auswertung von außen vereinfacht wird. Auf diese Weise kann eine zielgerichtete Überprüfung der Funktionsgruppen 4 bereits bei der Herstellung der elektronischen Baugruppe 36 zielgerichtet implementiert werden.

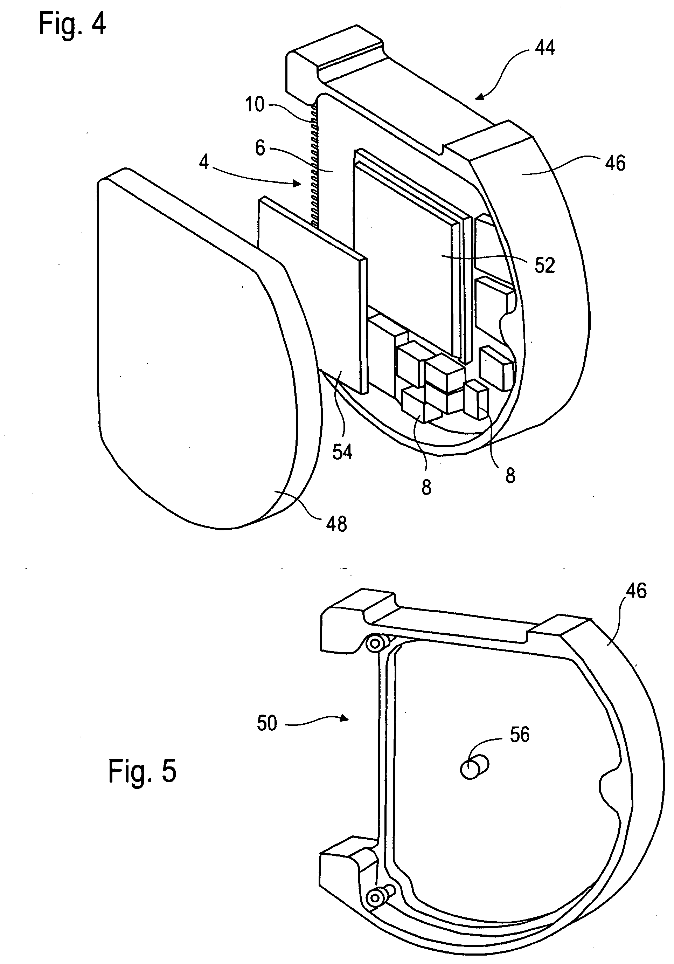

In den Fig. 3 bis 5 sind konkrete geometrische Realisierungen der elektronischen Baugruppe 2 dargestellt, wobei auch die Baugruppe 36 entsprechend ausgeführt sein kann. Wie aus Fig. 4 zu sehen ist, ist eine Funktionsgruppe 4 - und dies gilt für alle Funktionsgruppen 4 - in einem Gehäuse 44 gelagert, das aus einer Gehäusebasis 46 und einem mit der Gehäusebasis 46 zu verschraubenden Deckel 48 besteht. Durch eine seitliche Öffnung 50 (siehe Fig. 5) ragen die Kontaktstellen 10 des Plattenelements 6 durch das Gehäuse 44 nach außen. Auch das Plattenelement 6 ist in der Gehäusebasis 46 verschraubt.

Zur Kühlung des zentralen Prozessors 52 ist zwischen diesem und dem Gehäusedeckel 48 eine thermische Brücke 54 in Form eines Gelpads angeordnet, das bei verschlossenem Deckel 48 sowohl den Prozessor 52 als auch den Deckel 48 unmittelbar kontaktiert. Auf seiner anderen Seite ist der Prozessor 52 ebenfalls mit einer thermischen Senke verbunden, die durch eine Ausformung 56 - gegebenenfalls ebenfalls mit einem zusätzlichen Gelpad - realisiert ist, die das Plattenelement 6 auf seiner nicht dargestellten Rückseite unmittelbar oder über das Gelpad thermisch kontaktiert. Hierdurch wird das Plattenelement 6 in einem inneren Bereich, der vom Randbereich des Plattenelements 6 beabstandet ist, thermisch kontaktiert, sodass über die Ausformung 56 vom Prozessor 52 abgegebene Wärme direkt in das Gehäuse 44 geführt wird. Außerdem ist das Plattenelement 6 in seinem inneren Bereich mechanisch gehalten und hierdurch besonders geschützt gegen starke Vibrationen.

Die vier Gehäuse 44 der vier Funktionsgruppen 4 sind im fertigen Zustand der Baugruppe 2 miteinander verschraubt und bilden hierdurch einen mechanisch sehr stabilen Verbund. Dieser Verbund ist zusätzlich mit der Kontaktplatte 12 verschraubt, wie anhand angedeuteter Schrauben 58 dargestellt ist. Auch jede andere mechanische Befestigung durch ein anderes Befestigungsmittel ist denkbar.

Um diesen festen Verbund herumgelegt sind die Kontaktplatte 12, die leitungstragende Folie 24 und die Kommunikationseinheit 22, die zusammen die Funktionsgruppen 4 von zwei Seiten umgreifen. Hierdurch ist die Baugruppe 2 sehr kompakt ausgeführt. Mittels einer Verschraubung oder einer anderen geeigneten Befestigung ist die Kommunikationseinheit 22 außerdem mit den Funktionsgruppen 4 - im gezeigten konkreten Ausführungsbeispiel mit dem Gehäuse 44 zumindest einer Funktionsgruppe 4 - verbunden, sodass ein mechanisch besonders stabiler Verbund entsteht. Anhand einer äußeren Stützstruktur 60 ist die Baugruppe 2 mechanisch stabil in einer Umgehung, beispielsweise einem Lenkflugkörper, einbindbar. Die signaltechnische Verbindung nach außen geschieht hierbei über die beiden Schnittstellen 26, 28, die beispielsweise als Stecker ausgeführt sind und mit einem Sucher bzw. einem Lenkteil verbunden werden können. Beide Schnittstellen 26, 28 sind, analog zur Folie 24, über flexible Verbinder 62 mit der Kommunikationseinheit 22 verbunden, sodass die Kommunikationseinheit 22 auf drei Seiten (eine Seite ist nicht sichtbar, jedoch ebenso ausgeführt) in der Bauweise fest-flexibel-fest signaltechnisch kontaktiert ist.

Um eine besonders kompakte und Ressourcen sparende Geometrie der Baugruppe 2 zu erreichen, ist die Kommunikationseinheit 2 in einer bestimmten Geometrie zur Kontaktplatte 12 angeordnet. Bei dieser Geometrie schneiden die verlängert gedachten Plattenelemente 6 die Kommunikationseinheit 22. Bei einer kleineren Kommunikationseinheit 22 ist es ausreichend, wenn zumindest eines der Plattenelemente 6 in einer gedanklich verlängerten Form die Kommunikationseinheit 22 schneidet. Allgemein gesprochen ist die Kommunikationseinheit 22 über mehreren Datenleitungen 16, 18 mit der Kontaktplatte 12 verbunden, wobei die Datenleitungen 16, 18 auf derjenigen Seite 64 der Kontaktplatte 12 mit dieser verbunden sind, auf die die Reihen 66 der Kontaktstellen 10 der Plattenelemente 6 weisen, wie in Fig. 3 dargestellt ist.

Bei dem gezeigten Ausführungsbeispiel bilden Kontaktplatte 12 und Kommunikationseinheit 22 einen rechten Winkel zueinander, wobei andere Winkel ebenfalls denkbar sind. Eine Parallelität von Plattenelementen 6 und der Kommunikationseinheit 22 ist insbesondere nicht vorgesehen. Durch diese Geometrie können die Datenleitungen 16, 18 von den Funktionsgruppen 4 zur Kommunikationseinheit 22 geführt werden, ohne dass sie eine von den Reihen 66 jeweils gebildet gedachte Linie kreuzen müssen. Eine gedachte Linie in Verlängerung der Reihen 66, die jeweils parallel zu den ihm zugeordneten Plattenelement 6 sind, weist daher direkt auf die Seite 64 und auf die Kommunikationseinheit 22 oder eine entsprechende Kontaktierung von einer Datenleitung 16, 18 von der Kontaktplatte 12 zur Kommunikationseinheit 22.

### Bezugszeichenliste

- 2: Baugruppe
- 4: Funktionsgruppe
- 6: Plattenelement
- 8: Baustein
- 10: Kontaktstelle
- 12: Kontaktplatte
- 14: Kontaktaufnahme
- 16: Datenleitung
- 18: Datenleitung
- 20: Stromversorgungsleitung
- 22: Kommunikationseinheit
- 24: Folie
- 26: Schnittstelle
- 28: Schnittstelle
- 30: Stromversorgungseinheit
- 32: Bauelement
- 34: Bauelement
- 36: Baugruppe
- 38: Kontaktplatte
- 40: Kommunikationseinheit
- 42: Router
- 44: Gehäuse
- 46: Gehäusebasis
- 48: Deckel
- 50: Öffnung
- 52: Prozessor
- 54: Brücke
- 56: Ausformung
- 58: Schraube
- 60: Stützstruktur
- 62: Verbinder
- 64: Seite
- 66: Reihe

## Patentansprüche

1. Elektronische Baugruppe (2, 36) zur eigenständigen Steuerung eines Systems wie eines Flugkörpers mit mehreren Funktionseinheiten (4), die jeweils ein mit elektronischen Bausteinen (8) bestücktes Plattenelement (6) umfassen, das jeweils eine Anzahl von in zumindest einer Reihe angeordnete Kontaktstellen (10) aufweist, und mit einer Kontaktplatte (12, 38), die für jedes Plattenelement (6) zumindest eine Reihe (66) Kontaktaufnahmen (14) aufweist, die mit den Kontaktstellen (10) ihres Plattenelements (6) unmittelbar elektrisch verbunden sind, und diese Reihen (66) in ihrer Längsrichtung auf eine Seite (64) der Kontaktplatte (12, 38) weisen,
**gekennzeichnet**
**durch** eine von der Kontaktplatte (12, 38) separate Kommunikationseinheit (22, 40) zur Kommunikation mit Bausteinen (8) der Plattenelemente (6), die über mehrere Datenleitungen (16, 18) mit der Kontaktplatte (12, 38) verbunden ist, wobei die Datenleitungen (16, 18) auf der Seite (64) mit der Kontaktplatte (12, 38) kontaktiert sind, auf die die Reihen (66) weisen.

2. Elektronische Baugruppe (2, 36) nach Anspruch 1,
**dadurch gekennzeichnet,**
**dass** die Datenleitungen (16, 18) signaltechnisch unmittelbar mit den Plattenelementen (6) verbunden sind.

3. Elektronische Baugruppe (2, 36) nach Anspruch 1 oder 2,
**dadurch gekennzeichnet,**
**dass** die Datenleitungen (16, 18) zur Kommunikationseinheit in einem flexiblen Band (24) verlaufen und weitere Datenleitungen (16, 18) von der Kommunikationseinheit (22, 40) in Richtung einer Schnittstelle (26, 28) nach außen in einem flexiblen Band (62) verlaufen.

4. Elektronische Baugruppe (2, 36) nach einem der vorhergehenden Ansprüche,
**dadurch gekennzeichnet,**
**dass** die Kommunikationseinheit (12, 40) eine Platte ist und angewinkelt zur Kontaktplatte (12, 38) ist.

5. Elektronische Baugruppe (2, 36) nach einem der vorhergehenden Ansprüche,
**dadurch gekennzeichnet,**
**dass** die Kommunikationseinheit (22, 40) und die Kontaktplatte (12, 38) die Plattenelemente (6) von zwei Seiten umgreifen.

6. Elektronische Baugruppe (2, 36) nach einem der vorhergehenden Ansprüche,
**dadurch gekennzeichnet,**
**dass** die Kontaktplatte (12, 38) passiv ist.

7. Elektronische Baugruppe (2, 36) nach einem der vorhergehenden Ansprüche,
**dadurch gekennzeichnet,**
**dass** die Kommunikationseinheit (22, 40) aktiv ist.

8. Elektronische Baugruppe (2, 36) nach einem der vorhergehenden Ansprüche,
**dadurch gekennzeichnet,**
**dass** zumindest zwei der Plattenelemente (6) von jeweils einem Gehäuse (44) umgeben sind und die Gehäuse (44) starr miteinander verbunden sind.

9. Elektronische Baugruppe (2, 36) nach Anspruch 8,
**dadurch gekennzeichnet,**
**dass** das Gehäuse (44) eine Ausformung (56) aufweist, die einen inneren Bereich des jeweiligen Plattenelements (6) mechanisch kontaktiert.

10. Elektronische Baugruppe (2, 36) nach Anspruch 8 oder 9,
**dadurch gekennzeichnet,**
**dass** das Gehäuse (44) metallisch ist und eine Ausformung (56) des Gehäuses das jeweilige Plattenelement (6) thermisch kontaktiert.

## Claims

1. Electronic assembly (2, 36) for the autonomous control of a system, such as a missile, having a plurality of functional units (4) each comprising a board element (6) populated with electronic modules (8), which board element has in each case a number of contact locations (10) arranged in at least one row, and having a contact board (12, 38), which has for each board element (6) at least one row (66) of contact receptacles (14) which are directly electrically connected to the contact locations (10) of their board element (6) and these rows (66) point toward a side (64) of the contact board (12, 38) in their longitudinal direction,
**characterized**
**by** a communication unit (22, 40) separate from the contact board (12, 38) and serving for communication with modules (8) of the board elements (6), said communication unit being connected to the contact board (12, 38) via a plurality of data lines (16, 18), the data lines (16, 18) being contact-connected to the contact board (12, 38) on the side (64) to which the rows (66) point.

2. Electronic assembly (2, 36) according to Claim 1,
**characterized**
**in that** the data lines (16, 18) are connected directly to the board elements (6) in terms of signaling.

3. Electronic assembly (2, 36) according to Claim 1 or 2,
**characterized**
**in that** the data lines (16, 18) run to the communication unit in a flexible strip (24) and further data lines (16, 18) run from the communication unit (22, 40) in the direction of an interface (26, 28) toward the outside in a flexible strip (62).

4. Electronic assembly (2, 36) according to any of the preceding claims,
**characterized**
**in that** the communication unit (12, 40) is a board and is angled with respect to the contact board (12, 38).

5. Electronic assembly (2, 36) according to any of the preceding claims,
**characterized**
**in that** the communication unit (22, 40) and the contact board (12, 38) reach around the board elements (6) from two sides.

6. Electronic assembly (2, 36) according to any of the preceding claims,
**characterized**
**in that** the contact board (12, 38) is passive.

7. Electronic assembly (2, 36) according to any of the preceding claims,
**characterized**
**in that** the communication unit (22, 40) is active.

8. Electronic assembly (2, 36) according to any of the preceding claims,
**characterized**
**in that** at least two of the board elements (6) are surrounded by a respective housing (44) and the housings (44) are rigidly connected to one another.

9. Electronic assembly (2, 36) according to Claim 8,
**characterized**
**in that** the housing (44) has a shaped portion (56) which makes mechanical contact with an inner region of the respective board element (6).

10. Electronic assembly (2, 36) according to Claim 8 or 9,
**characterized**
**in that** the housing (44) is metallic and a shaped portion (56) of the housing makes thermal contact with the respective board element (6).

## Revendications

1. Sous-ensemble électronique (2, 36) destiné à la commande autonome d'un système tel qu'un missile, doté de plusieurs unités fonctionnelles (4) qui comprennent respectivement un élément en plaque (6) équipé de composants électroniques (8), lequel possède respectivement un certain nombre de points de contact (10) disposés en au moins une rangée, et doté d'une plaque de contact (12, 38) qui, pour chaque élément en plaque (6), possède au moins une rangée (66) de logements de contact (14) qui sont reliés électriquement directement aux points de contact (10) de leur élément en plaque (6) et ces rangées (66), dans leur orientation longitudinale, pointent sur un côté (64) de la plaque de contact (12, 38),
**caractérisé**
**par** une unité de communication (22, 40) séparée de la plaque de contact (12, 38) destinée à communiquer avec les composants (8) des éléments en plaque (6), laquelle est reliée à la plaque de contact (12, 38) par le biais de plusieurs lignes de données (16, 18), les lignes de données (16, 18) étant mises en contact avec la plaque de contact (12, 38) sur le côté (64) sur lequel pointent les rangées (66).

2. Sous-ensemble électronique (2, 36) selon la revendication 1, **caractérisé en ce que** les lignes de données (16, 18) sont reliées directement aux éléments en plaque (6) du point de vue de la technique des signaux.

3. Sous-ensemble électronique (2, 36) selon la revendication 1 ou 2, **caractérisé en ce que** les lignes de données (16, 18) s'étendent vers l'unité de communication dans une bande souple (24) et des lignes de données (16, 18) supplémentaires s'étendent de l'unité de communication (22, 40) en direction d'une interface (26, 28) vers l'extérieur dans une bande souple (62).

4. Sous-ensemble électronique (2, 36) selon l'une, des revendications précédentes, **caractérisé en ce que** l'unité de communication (12, 40) est une plaque non alignée sur la plaque de contact (12, 38).

5. Sous-ensemble électronique (2, 36) selon l'une des revendications précédentes, **caractérisé en ce que** l'unité de communication (12, 40) et la plaque de contact (12, 38) enveloppent les éléments en plaque (6) par deux côtés.

6. Sous-ensemble électronique (2, 36) selon l'une des revendications précédentes, **caractérisé en ce que** la plaque de contact (12, 38) est passive.

7. Sous-ensemble électronique (2, 36) selon l'une des revendications précédentes, **caractérisé en ce que** l'unité de communication (12, 40) est active.

8. Sous-ensemble électronique (2, 36) selon l'une des revendications précédentes, **caractérisé en ce qu'**au moins deux des éléments en plaque (6) sont respectivement entourés par un boîtier (44) et les boîtiers (44) sont reliés l'un à l'autre de manière rigide.

9. Sous-ensemble électronique (2, 36) selon la revendication 8, **caractérisé en ce que** le boîtier (44) possède un façonnage (56) qui entre en contact mécanique avec une zone intérieure de l'élément en plaque (6) correspondant.

10. Sous-ensemble électronique (2, 36) selon la revendication 8 ou 9, **caractérisé en ce que** le boîtier (44) est métallique et entre en contact thermique avec un façonnage (56) du boîtier de l'élément en plaque (6) correspondant.
